# EUROPÄISCHE PATENTSCHRIFT

(11) **EP 1 198 979 B1**
(45) Veröffentlichungstag und Bekanntmachung des Hinweises auf die Patenterteilung: **05.03.2003**
(21) Anmeldenummer: 00940417.9
(22) Anmeldetag: 30.06.2000
(51) Int. Cl.: H05K 13/04

(54) **INSPEKTIONSVORRICHTUNG FÜR BAUTEILE**
INSPECTION DEVICE FOR COMPONENTS
DISPOSITIF D'INSPECTION POUR COMPOSANTS

(30) Priorität: 23.07.1999 DE 19934619
(43) Veröffentlichungstag der Anmeldung: 24.04.2002
(73) Patentinhaber: Pulsotronic Merten GmbH & Co. KG, 51674 Wiehl-Bomig (DE)
(72) Erfinder: BOLLINGER, Peter, D-56154 Boppard-Udenhausen (DE)
(74) Vertreter: Selting, Günther, Dipl.-Ing.
(86) Internationale Anmeldenummer: EP0006117
(87) Internationale Veröffentlichungsnummer: WO01008461

(56) Entgegenhaltungen:
- EP-A- 0 862 355
- EP-A- 0 878 992
- WO-A-96/12395
- WO-A-99/00661
- DE-A- 19 821 800
- US-A- 4 914 513

## Beschreibung

Die Erfindung betrifft eine Inspektionsvorrichtung für Bauteile, mit einer Videokamera, die Bilder des Bauteils aufnimmt.

Die Bestückung elektrischer Leiterplatten mit Bauteilen erfolgt in der Serienfertigung mit Bestückungsautomaten, die das jeweilige Bauteil an seinen Platz bringen, damit es dort verlötet oder verbondet werden kann. Die Bauteile, bei denen es sich oft um miniaturisierte Bauteile handelt, deren Größe in der Größenordnung von 1 bis 10 mm liegt, müssen vor ihrer Verarbeitung inspiziert werden, um sicherzustellen, daß das Bauteil für eine Verarbeitung intakt ist. Insbesondere muß sichergestellt werden, daß sämtliche Beine des Bauteils vorhanden sind und die korrekte Lage einnehmen. Eine solche Inspektion erfolgt üblicherweise mit einer Videokamera und einem angeschlossenen Rechner, der zur Bildverarbeitung geeignet ist und das aufgenommene Videobild mit einem zuvor gespeicherten Standardbild des Bauteils vergleicht. Auf diese Weise kann ohne menschlichen Eingriff beurteilt werden, ob ein zu montierender oder anderweitig zu verarbeitender Gegenstand intakt ist.

Für eine komplette Inspektion ist es erforderlich, das Bauteil aus unterschiedlichen Richtungen aufzunehmen. Bei einem Bild, das nur aus einer einzigen Richtung aufgenommen ist, könnten Fehler des Bauteils verdeckt bleiben. Eine solche Inspektionsvorrichtung, die mehrere Bilder eines Bauteils aus verschiedenen Richtungen aufnimmt und auswertet, ist aus EP-A-0 862 355 bekannt.

Bei miniaturisierten Bauteilen ist die gleichzeitige Aufnahme mehrerer Bilder wegen der dann erforderlichen mehreren Videokameras aus Platzgründen schwierig.

Der Erfindung liegt die Aufgabe zugrunde, eine Inspektionsvorrichtung für Bauteile zu schaffen, die es erlaubt, Bilder des Bauteils aus unterschiedlichen Richtungen zeitgleich aufzunehmen und die auch für Miniaturbauteile geeignet ist.

Die Lösung dieser Aufgabe erfolgt erfindungsgemäß mit den im Patentanspruch 1 angegebenen Merkmalen.

Bei der erfindungsgemäßen Inspektionsvorrichtung werden von einer einzigen Videokamera mehrere Bilder des Bauteils aus unterschiedlichen Richtungen aufgenommen, wobei im Strahlengang mindestens eines der Bilder eine optische Umlenkvorrichtung angeordnet ist. Somit können beide Bilder, die aus unterschiedlichen Richtungen zeitgleich aufgenommen werden, der Videokamera aus derselben Empfangsrichtung zugeführt werden, so daß beide Bilder an unterschiedlichen Stellen des Videobildes reproduziert werden können. Erfindungsgemäß wird für die Reproduktion mehrerer Bilder eine einzige Videokamera benutzt. Somit erfolgt auch die Bildauswertung durch automatische Bildverarbeitung anhand eines einzigen Videobildes. Die Inspektionsvorrichtung kann unter räumlich sehr beengten Verhältnissen eingesetzt werden und eignet sich insbesondere für die Auswertung und Beurteilung von Miniaturbauteilen, weil es nicht erforderlich ist, mehrere Videokameras auf ein einziges Bauteil zu richten.

Als Videokamera eignet sich insbesondere eine CCD-Kamera mit einem Sensorfeld aus Ladungsspeicherelementen, die durch Lichtsignale beeinflußt werden. Die unterschiedlichen Bilder fallen zwar parallel zueinander auf das Objektiv der Videokamera, sind jedoch seitlich zueinander versetzt, so daß sie sich nicht gegenseitig überlagern.

Gemäß der Erfindung ist im Strahlenweg eines der Bilder zwischen Bauteil und Videokamera eine Längenausgleichsvorrichtung vorgesehen, die diesem Strahlenweg die gleiche Länge gibt, die der andere Strahlenweg hat. Auf diese Weise werden beide Bilder gemeinsam von der Videokamera scharfgestellt. Die Längenausgleichsvorrichtung kann aus Spiegeln bestehen oder vorzugsweise aus einer Prismenanordnung, die einen mäanderförmigen Strahlenweg erzeugt.

Die Erfindung bietet die Möglichkeit, mehrere Bauteile gleichzeitig mit der Videokamera abzubilden und auszuwerten. Hierzu ist eine Strahlzusammenlegungsvorrichtung vorgesehen, die die Bilder zweier beabstandeter Bauteile gleichzeitig der Videokamera zuleitet. Eine solche Strahlzusammenlegungsvorrichtung besteht aus einer Spiegelvorrichtung oder einer Prismenanordnung. Ihre Anwendung setzt voraus, daß die Bauteile jeweils gleichzeitig in zwei definierten beabstandeten Positionen vorhanden sind.

Für eine definierte und reproduzierbare Inspektion sind definierte Beleuchtungsverhältnisse erforderlich. Bei der Objektbeleuchtung müssen Blenderscheinungen und ähnliche Beeinflussungen vermieden werden. Gemäß einer Weiterbildung der Erfindung sind zwei Beleuchtungsvorrichtungen vorgesehen, von denen eine für das erste Bild und die andere für das zweite Bild des Bauteils bestimmt ist. Die beiden Beleuchtungsvorrichtungen senden Licht mit unterschiedlichen Lichteigenschaften aus, derart, daß das Licht des einen Bildes nicht von der Beleuchtung des anderen Bildes gestört wird. Die unterschiedlichen Lichteigenschaften können beispielsweise unterschiedliche Wellenlängen sein oder auch unterschiedliche Polarisationsrichtungen. Wichtig ist, daß für jedes Bild eine selektive Beleuchtung erfolgt, die von dem anderen Bild nicht wahrgenommen wird. Die Trennung der aufgenommenen Bilder kann durch entsprechende Filter erfolgen.

Bei einer bevorzugten Ausführungsform der Erfindung beleuchtet eine Beleuchtungsvorrichtung das Bauteil im Auflicht an derselben Seite, von der das Bild aufgenommen wird, und die andere Beleuchtungsvorrichtung beleuchtet das Bauteil im Gegenlicht. Die Aufnahmerichtungen der beiden Bilder sind vorzugsweise rechtwinklig zueinander.

Wenn die Beleuchtungsvorrichtungen Licht unterschiedlicher Wellenlängen aussenden, kann als Videokamera eine Schwarz/Weiß-Kamera oder auch eine Farbbildkamera benutzt werden. Bei einer Schwarz/Weiß-Kamera muß gewährleistet sein, daß sie für die beiden ausgewählten Wellenlängen empfindlich ist.

Im folgenden wird unter Bezugnahme auf die Zeichnungen ein Ausführungsbeispiel der Erfindung näher erläutert.

Es zeigen:
- Fig. 1: eine schematische Seitenansicht einer Inspektionsvorrichtung,
- Fig. 2: eine Ansicht aus Richtung des Pfeiles II von Fig. 4,
- Fig. 3: eine schematische Ansicht der konstruktiv ausgeführten Inspektionsvorrichtung aus gleicher Sicht wie Fig. 1,
- Fig. 4: eine Ansicht von Fig. 3 aus Richtung des Pfeiles IV,
- Fig. 5: eine Darstellung des in der Videokamera erzeugten Videobildes,
- Fig. 6: eine mechanische Darstellung der auf das Bauteil gerichteten Beleuchtungsvorrichtungen und
- Fig. 7: eine Ansicht aus Richtung des Pfeiles VII von Fig. 6.

Die Inspektionsvorrichtung weist zahlreiche Tragvorrichtungen 10 auf, bei denen es sich hier um Saugpipetten handelt, die durch eine dünne Saugöffnung hindurch Luft ansaugen und damit das Bauteil 11 gegen die Luftansaugöffnung ziehen und festhalten. Die Haltevorrichtungen 10 sind in einer Reihe an einem endlos umlaufenden Förderer angebracht, der in einem Maschinentakt schrittweise weiterbewegt wird.

Die Bauteile 11 sind hier beispielsweise Transistoren mit einem Körper 12 und davon nach entgegengesetzten Seiten abstehenden Beinen 13,14. Nach der einen Seite stehen zwei Beine 13 und nach der anderen ein Bein 14 ab. Die Beine sind zweifach abgewinkelt und sie haben jeweils einen Aufsetzabschnitt 15, der flach auf eine Leiterplatte aufgesetzt und mit einer Leiterbahn verlötet werden kann. Die Inspektionsvorrichtung prüft unter anderem, ob die Beine 13 und 14 sämtlich vorhanden sind und ob diese Beine korrekt stehen.

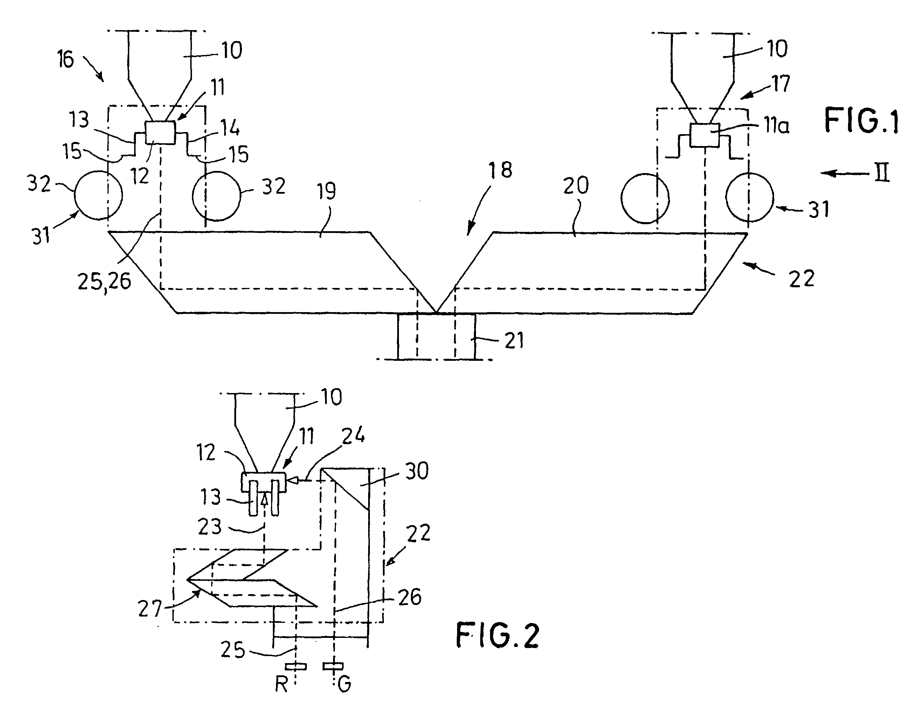

Gemäß Fig. 1 sind an zwei Stellen des Förderweges der Tragvorrichtungen 10 Aufnahmepositionen 16,17 vorgesehen, an denen eine Abbildung der Bauteile 11,11a mit einer Videokamera erfolgt. Zwischen beiden Aufnahmepositionen erstreckt sich eine Strahlzusammenlegungsvorrichtung 18 aus einem ersten Prisma 19 und einem zweiten Prisma 20. Jedes dieser Prismen 19,20 lenkt ein Bild des betreffenden Bauteils 11 bzw. 11a zu dem Kameraobjektiv 21, wobei die Strahlenwege beider Bilder gestrichelt dargestellt sind. Man erkennt, daß beide Bilder parallel zueinander in das Objektiv 21 eingegeben werden, jedoch mit seitlichem Versatz, so daß auf dem Sensor der Videokamera beide Bilder an unterschiedlichen Stellen abgebildet werden. Die Strahlenwege von den beiden Bauteilen 11,11a zum Objektiv 21 sind in Fig. 1 gestrichelt dargestellt. Diese Strahlenwege verlaufen zunächst parallel zueinander in großem Abstand, um dann rechtwinklig aufeinander zuzulaufen und schließlich parallel zueinander mit geringem Abstand in das Objektiv 21 einzumünden.

Die Strahlzusammenlegungsvorrichtung 18 und die Aufnahmepositionen 16,17 befinden sich in einem Objektivvorsatz 22, der an dem Objektiv 21 der Videokamera befestigt und diesem vorgesetzt ist. An diesem Vorsatz 22 bewegen sich die Tragvorrichtungen 10 entlang.

Fig. 2 zeigt ein Bauteil 11, das von einer Tragvorrichtung 10 angesaugt und festgehalten wird, aus Richtung des Pfeiles II von Fig. 1. Das Bauteil wird von der Videokamera aus einer ersten Richtung 23 (von unten) und aus einer zweiten Richtung 24 (von der Seite) aufgenommen. Die beiden Richtungen 23,24 verlaufen rechtwinklig zueinander. Die Richtung 23 ist Bestandteil eines Strahlenweges 25 und die Richtung 24 ist Bestandteil eines Strahlenweges 26. Die Richtungen 23,24 geben die Blickrichtung der Videokamera an. Die Lichtstrahlen verlaufen dagegen in umgekehrter Richtung von dem Bauteil zur Videokamera.

Im Strahlenweg 25 befindet sich eine aus zwei Prismen bestehende Längenausgleichsvorrichtung 27, die den Strahlenweg 25 verlängert und ihn so lang macht wie der andere Strahlenweg 26. Dadurch, daß beide Strahlenwege 25,26 im wesentlichen die gleiche Länge haben, ist eine Scharfeinstellung beider Bilder an der Videokamera möglich. Die Längenausgleichsvorrichtung 27 ist so ausgebildet, daß der ankommende Strahl und der abgehende Strahl parallel verlaufen.

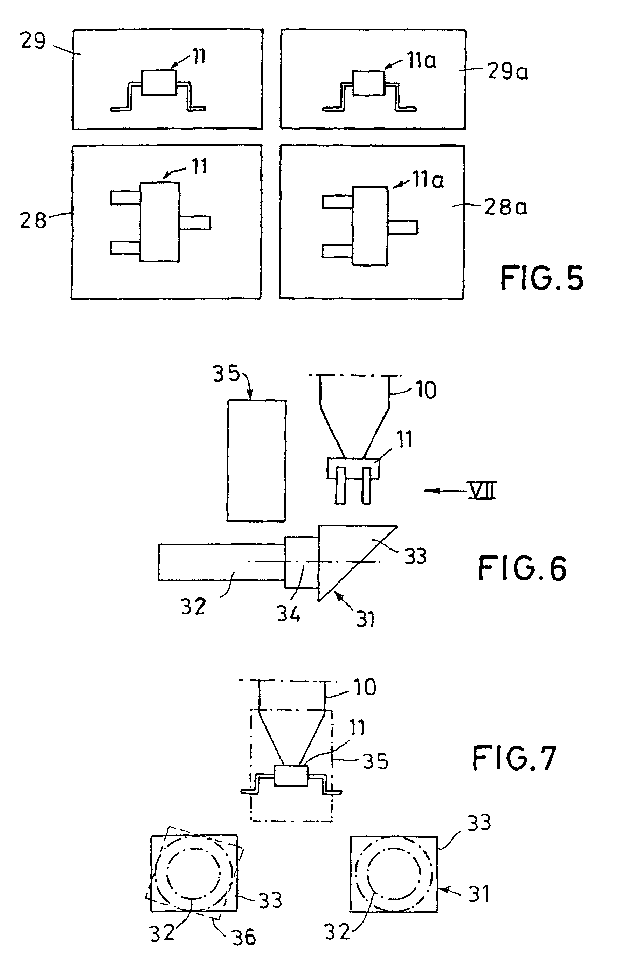

Fig. 5 zeigt das Videobild, das von den beiden Bauteilen 11,11a erzeugt wird. Das Bauteil 11 wird in zwei Bildern 28,29 wiedergegeben, wobei das Bild 28 eine Draufsicht und das Bild 29 eine Seitenansicht darstellt. Das Bauteil 11a wird ebenfalls in zwei Bildern 28a,29a wiedergegeben. Alle vier Bilder werden gemeinsam auf dem Sensor der Videokamera erzeugt und können auf einem Bildschirm gemeinsam wiedergegeben werden.

Der Strahlenweg 26, der zunächst parallel zu dem Strahlenweg 25 verläuft, wird von einer optischen Umlenkvorrichtung 30 rechtwinklig angelenkt, um dann aus der Richtung 24 seitlich auf das Bauteil 11 zu treffen.

Die Beleuchtung des Bauteils erfolgt für jedes der beiden Bilder 28,29 mit Licht unterschiedlicher Eigenschaften. Eine erste Beleuchtungsvorrichtung 31 (Fign. 6 und 7) beleuchtet das Bauteil 11 von unten. Diese Beleuchtungsvorrichtung 31 weist zwei Lichtquellen 32 auf, die horizontal angeordnet sind und deren Licht durch jeweils ein Prisma 33 senkrecht nach oben gelenkt wird. Die Lichtquellen 32 können zusammen mit dem zugehörigen Prisma 33 um die Hauptabstrahlachse 34 herum gedreht und eingestellt werden, um unterschiedliche Kippwinkel einzustellen, wie dies in Fig. 7 bei 34 dargestellt ist. Die Lichtquellen 32 sind mit gegenseitigem Abstand angeordnet, so daß sich jede Lichtquelle schräg unter dem Bauteil 11 befindet. Der Strahlenweg der Videokamera geht zwischen den beiden Lichtquellen 32 hindurch. Die Unterseite des Bauteils 11 wird im Auflicht aufgenommen, indem sie von der Beleuchtungsvorrichtung 31 angestrahlt wird.

Die zweite Beleuchtungsvorrichtung 35 ist seitlich neben dem Bauteil 11 angeordnet, und zwar auf der der Aufnahmeseite gegenüberliegenden Seite. Dies bedeutet, daß die Aufnahmerichtung 24 auf die Beleuchtungsvorrichtung 35 zeigt. Das Bauteil 11 wird aus dieser Richtung 24 im Gegenlicht aufgenommen, d.h. das entsprechende Bild 29 zeigt eine Silhouette des Bauteils.

Die Beleuchtungsvorrichtungen 31,35 arbeiten mit Licht unterschiedlicher Wellenlängen. Die Lichtquellen der Beleuchtungsvorrichtung 31 senden beispielsweise rotes Licht und diejenigen der Beleuchtungsvorrichtung 35 senden grünes Licht aus. Demgemäß befindet sich gemäß Fig. 2 im Strahlenweg 25 ein Rotfilter R, welches nur rotes Licht durchläßt, und im Strahlenweg 26 befindet sich ein Grünfilter G, welches nur grünes Licht durchläßt. Somit wird das Bild 28 bei rotem Licht und das Bild 29 bei grünem Licht aufgenommen. Beide Lichtarten stören sich gegenseitig nicht und insbesondere treten keine störenden Blenderscheinungen auf.

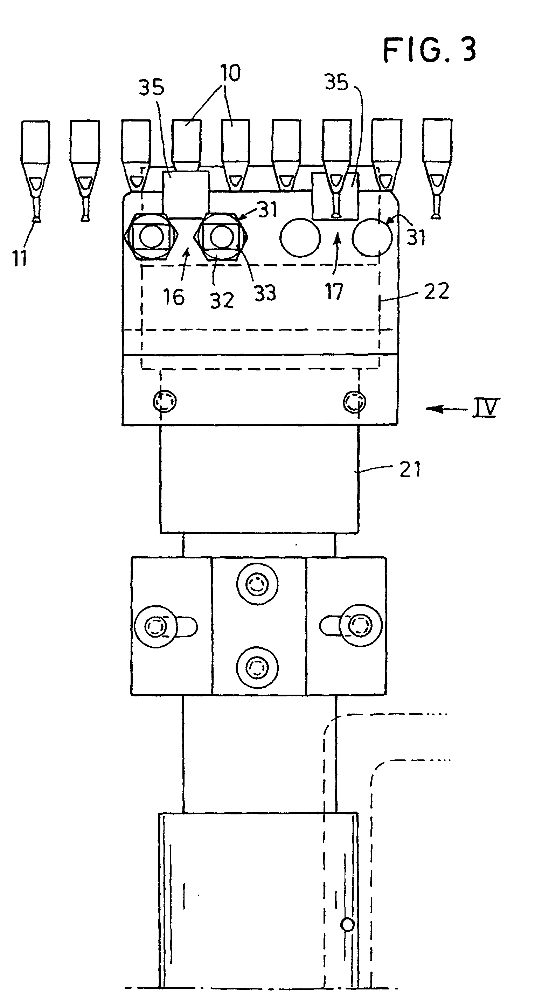

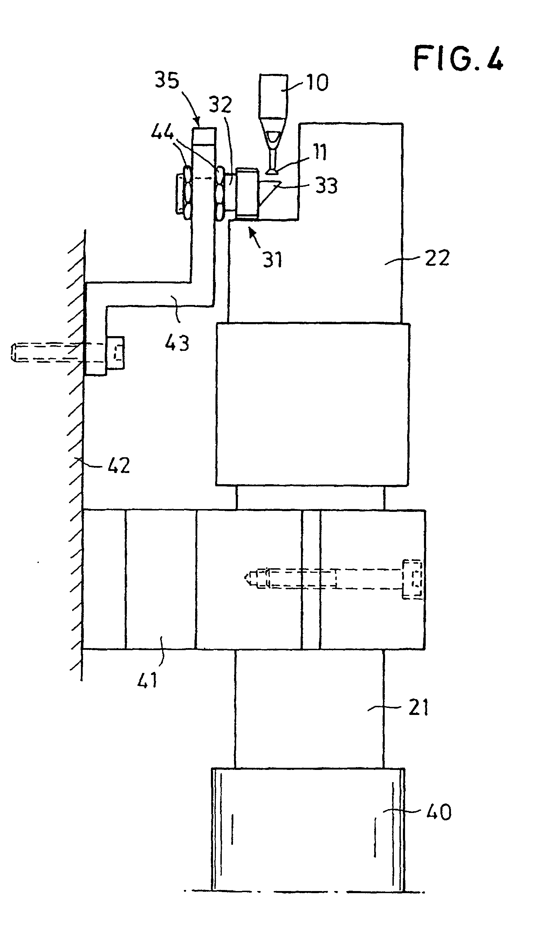

Die Fign. 3 und 4 zeigen den konstruktiven Aufbau der Inspektionsvorrichtung. Unmittelbar vor dem Objektiv 21 der Videokamera 40 ist der Vorsatz 22 befestigt, der die in den Fign. 1 und 2 dargestellten Komponenten enthält. Das Objektiv 21 der Videokamera 40 ist mit einem Halter 41 an dem Maschinenrahmen 42 befestigt. Ein Winkelhalter 43 trägt die Beleuchtungsvorrichtung 31. An diesem Winkelhalter sind die Lichtquellen 32 mit Schrauben 44 befestigt. Das Prisma 33, welches das Licht der Lichtquelle 32 nach oben richtet, befindet sich unterhalb des Laufweges der Halter 10. Die Bauteile 11 durchlaufen den Transportweg in der Weise, daß ihre Beine 13,14 nach vorne und nach hinten weisen. Die Beleuchtungsvorrichtung 35 befindet sich als Leuchtdiodenfeld an dem Winkelhalter 43.

## Patentansprüche

1. Inspektionsvorrichtung für Bauteile (11), mit einer Videokamera (40), die ein erstes Bild (28) des Bauteils (11) aus einer ersten Richtung (23) aufnimmt, und einer optischen Umlenkvorrichtung (30), die ein zweites Bild (29) des Bauteils (11), das aus einer zweiten Richtung (24) erhalten wird, der Videokamera (40) zuführt, wobei beide Bilder (28,29) an unterschiedlichen Stellen des von der Videokamera erzeugten Videobildes reproduziert werden,
**dadurch gekennzeichnet,**
**daß** die Richtungen, aus denen die beiden Bilder aufgenommen werden, auf verschiedene Seiten des Bauteils gerichtet sind und daß im Strahlenweg (25) eines der Bilder (28,29) zwischen Bauteil (11) und Videokamera (40) eine Längenausgleichsvorrichtung (27) vorgesehen ist, die diesem Strahlenweg die gleiche Länge gibt, die der andere Strahlenweg (26) hat.

2. Inspektionsvorrichtung nach Anspruch 1, **dadurch gekennzeichnet, daß** die Strahlenwege (25,26) beider Bilder (28,29) parallel zueinander auf die Videokamera (40) stoßen.

3. Inspektionsvorrichtung nach Anspruch 1 oder 2, **dadurch gekennzeichnet, daß** eine Strahlzusammenlegungsvorrichtung (18) vorgesehen ist, die die Bilder zweier beabstandeter Bauteile (11,11a) gleichzeitig der Videokamera (40) zuleitet.

4. Inspektionsvorrichtung nach einem der Ansprüche 1-3, **dadurch gekennzeichnet, daß** eine erste Beleuchtungsvorrichtung (31) vorgesehen ist, die das Bauteil (11) für die Erzeugung des ersten Bildes (28) beleuchtet, und eine zweite Beleuchtungsvorrichtung (35), die das Bauteil (11) für die Erzeugung des zweiten Bildes (29) beleuchtet, und daß die Beleuchtungsvorrichtungen (31,35) Licht mit unterschiedlichen Lichteigenschaften aussenden derart, daß das Licht des einen Bildes nicht von der Beleuchtung des anderen Bildes gestört wird.

5. Inspektionsvorrichtung nach Anspruch 4, **dadurch gekennzeichnet, daß** die unterschiedlichen Lichteigenschaften unterschiedliche Wellenlängen sind.

6. Inspektionsvorrichtung nach einem der Ansprüche 4 oder 5, **dadurch gekennzeichnet, daß** eine Beleuchtungsvorrichtung (31) das Bauteil (11) im Auflicht an derselben Seite beleuchtet, von der das Bild (28) aufgenommen wird, und daß die andere Beleuchtungsvorrichtung (35) das Bauteil (11) im Gegenlicht beleuchtet.

7. Inspektionsvorrichtung nach einem der Ansprüche 4-6, **dadurch gekennzeichnet, daß** mindestens eine Beleuchtungsvorrichtung (31) eine Lichtquelle (32) enthält, die um die Hauptstrahlachse (34) drehbar montiert und mit einer mitdrehenden Ablenkvorrichtung (33) verbunden ist.

8. Inspektionsvorrichtung nach einem der Ansprüche 4-7, **dadurch gekennzeichnet, daß** eine Beleuchtungsvorrichtung (31) zwei Lichtquellen (32) aufweist, und daß der Strahlenweg (25) eines der Bilder (28) zwischen diesen Lichtquellen hindurch verläuft.

## Claims

1. An inspection device for components (11), comprising a video camera (40) recording a first picture (28) of the component (11) from a first direction (23), and an optical deflection device (30) which supplies a second picture (29) of the component (11) to the video camera (40), the second picture being taken from a direction (24) different from the first direction (23), and both pictures (28, 29) are reproduced at different locations of the video image produced by the video camera,
**characterized in that**
the directions from which the two pictures are taken are oriented towards different sides of the component and that in the beam path (25) of one of the pictures (28, 29) between the component (11) and the video camera (40) a length compensation device (27) is provided which makes the length of this beam path equal to that of the other beam path (26).

2. The inspection device of claim 1, **characterized in that** the beam paths (25, 26) of both pictures (28, 29) are incident in parallel into the video camera (40).

3. The inspection device of claim 1 or 2, **characterized in that** a beam combining device (18) is provided that directs the pictures of two spaced components (11, 11a) simultaneously to the video camera (40).

4. The inspection device of one of claims 1-3, **characterized in that** a first illumination device (31) is provided that illuminates the component (11) to generate the first picture (28), and a second illumination device (35) is provided that illuminates the component (11) for generating the second picture (29), and that the illumination devices (31, 35) emit light of different light characteristics such that the light of one picture is not affected by the illumination of the other picture.

5. The inspection device of claim 4, **characterized in that** the different light characteristics are different wavelengths.

6. The inspection device of claim 4 or 5, **characterized in that** one illumination device (31) illuminates the component directly at the same side where the picture (28) is taken, and that the other illumination device (35) illuminates the component (11) with counter light.

7. The inspection device of one of claims 4-6, **characterized in that** at least one illumination device (31) comprises a light source (32) mounted for rotation about the main beam axis (34) and connected to a deflection device (33) rotating together therewith.

8. The inspection device of one of claims 4-7, **characterized in that** an illumination device (31) comprises two light sources (32), and that the beam path (25) of one of the pictures (28) passes between these light sources.

## Revendications

1. Dispositif d'inspection pour composants (11), comprenant une caméra vidéo (40), qui prend une première image (28) du composant (11) à partir d'une première direction (23), et un dispositif optique d'inversion (30) qui amène à la caméra vidéo (40) une seconde image (29) du composant (11), qui est obtenue à partir d'une seconde direction, les deux images (28, 29) étant reproduites à différents endroits de l'image vidéo produite par la caméra vidéo,
**caractérisé en ce que** les directions à partir desquelles les deux images sont prises sont dirigées sur différentes faces du composant et **en ce que**, dans le trajet (25) du faisceau de l'une des images (28, 29), est prévu entre composant (11) et caméra vidéo (40), un dispositif d'équilibrage en longueur (27) qui donne à ce trajet de faisceau la même longueur que celle de l'autre trajet de faisceau (26).

2. Dispositif d'inspection selon la revendication 1, **caractérisé en ce que** les trajets de faisceaux (25, 26) des deux images (28, 29) arrivent parallèlement l'un à l'autre sur la caméra vidéo (40).

3. Dispositif d'inspection selon la revendication 1 ou 2, **caractérisé en ce qu'**il est prévu un dispositif de réunion des faisceaux qui conduit en même temps les images de deux composants écartés l'un de l'autre (11, 11a) à la caméra vidéo (40).

4. Dispositif d'inspection selon l'une des revendications 1 à 3, **caractérisé en ce qu'**il est prévu un premier dispositif d'éclairage (31) qui éclaire le composant (11) pour la production de la première image (28) et un second dispositif d'éclairage (35), qui éclaire le composant (11) pour la production de la seconde image (29), et **en ce que** les dispositifs d'éclairage (31, 35) émettent de la lumière ayant des caractéristiques de lumière différentes, de façon que la lumière d'une première image n'est pas perturbée par l'éclairage de l'autre image.

5. Dispositif d'inspection selon la revendication 4, **caractérisé en ce que** les caractéristiques de lumière différentes consistent en des longueurs d'ondes différentes.

6. Dispositif d'inspection selon l'une des revendications 4 ou 5, **caractérisé en ce qu'**un dispositif d'éclairage (31) éclaire le composant (11) en lumière incidente sur la face à partir de laquelle l'image (28) est prise, et **en ce que** l'autre dispositif d'éclairage (35) éclaire le composant (11) à contre-jour.

7. Dispositif d'inspection selon l'une des revendications 4 à 6, **caractérisé en ce qu'**au moins un dispositif d'éclairage (31) contient une source lumineuse (32) qui est montée rotative autour de l'axe du faisceau principal (34) et est reliée à un dispositif de déviation (33) tournant avec celle-ci.

8. Dispositif d'inspection selon l'une des revendications 4 à 7, **caractérisé en ce qu'**un dispositif d'éclairage (31) présente deux sources lumineuses (32) et **en ce que** le trajet du faisceau (25) de l'une des images (28) passe entre ces sources lumineuses.
